# EUROPEAN PATENT SPECIFICATION

(11) **EP 2 483 907 B1**
(45) Date of publication and mention of the grant of the patent: **27.07.2016**
(21) Application number: 10760679.0
(22) Date of filing: 30.09.2010
(51) Int. Cl.: H01J 37/34

(54) **Method for coating a substrate**
Verfahren zur Beschichtung eines Substrats
Procédé de revêtement d'un substrat

(30) Priority: 02.10.2009 EP 09172133
(43) Date of publication of application: 08.08.2012
(73) Proprietor: Applied Materials, Inc., Santa Clara, CA 95054 (US)
(72) Inventor: BENDER, Marcus, 63454 Hanau (DE); HANIKA, Markus, 86899 Landsberg (DE); SCHEER, Evelyn, 63811 Stockstadt (DE); PIERALISI, Fabio, 63739 Aschaffenburg (DE); MAHNKE, Guido, 63814 Mainaschaff (DE)
(74) Representative: Zimmermann & Partner Patentanwälte mbB
(86) International application number: PCT/EP2010/064574
(87) International publication number: WO 2011/039316

(56) References cited:
- WO-A2-2009/022184
- US-A1- 2008 047 831
- US-A1- 2008 289 957

## Description

### FIELD OF THE INVENTION

The present disclosure relates to a method for coating a substrate. More specifically, it relates to a method for coating a substrate, in particular by sputtering. More specifically, the present disclosure is directed at magnetron sputtering wherein the target is typically a rotatable target. Even more specifically, the method is directed at static sputtering deposition. The present disclosure particularly relates to substrate coating technology solutions involving equipment, processes and materials used in the deposition, patterning, and treatment of substrates and coatings, with representative examples including (but not limited to) applications involving: semiconductor and dielectric materials and devices, silicon-based wafers, flat panel displays (such as TFTs), masks and filters, energy conversion and storage (such as photovoltaic cells, fuel cells, and batteries), solid-state lighting (such as LEDs and OLEDs), magnetic and optical storage, micro-electro-mechanical systems (MEMS) and nano-electro-mechanical systems (NEMS), micro-optic and opto-elecro-mechanical systems (NEMS), micro-optic and optoelectronic devices, transparent substrates, architectural and automotive glasses, metallization systems for metal and polymer foils and packaging, and micro- and nano-molding.

### BACKGROUND OF THE INVENTION

In many applications, it is desired to deposit a thin layer of a coating material on a substrate. Known techniques for depositing layers are particularly evaporating and sputtering.

Sputtering is a vacuum coating process used to deposit thin films of various materials onto the surface of a substrate. For example, sputtering can be used to deposit a metal layer such as a thin layer of aluminium or ceramics. During the sputtering process, the coating material is transported from a target consisting of that material to the substrate to be coated by bombarding the surface of the target with ions of an inert gas or reactive gas that are accelerated by a high voltage. When the gas ions hit the outer surface of the target, their momentum is transferred to the atoms of the material so that some of them can gain sufficient energy to overcome their bonding energy in order to escape from the target surface and to deposit on the substrate. Thereon, they form a film of the desired material. The thickness of the deposited film is, inter alia, dependent on the duration of exposing the substrate to the sputtering process. For instance, US 2008/289957 A1 and US 2008/047831 A1 disclose sputtering methods and apparatuses used therein.

It is an ongoing desire to further improve the quality of the deposited layers. It is desired to have a high homogeneity of the layer on the substrate when coating a substrate with a layer. In particular, it is desired that the thickness of the deposited layer on the substrate is as uniform as possible throughout the whole substrate. It is further desired to have a high degree of homogeneity in terms of characteristics such as the grown crystal structure, the specific resistance, and the stress of the layer. For instance, in the production of metalized layers the signal delay is dependent on the thickness of the layer so that, e.g., in the production of displays a varying thickness might result in pixels that are energized at slightly different times. It is further important to rely on a uniform layer thickness when etching a layer in order to achieve the same results at different positions.

In order to improve these characteristics of a deposited layer, it has been proposed to wiggle the magnets within a rotatable target during sputtering. In other words, it has been suggested that the magnet of a magnetron sputter cathode is constantly moved with constant angular velocity in between certain maximum outer positions around the zero-position.

It turns out, however, that this results in a homogeneity that can still be improved.

### SUMMARY OF THE INVENTION

In view of the above, a method for coating a substrate provided.

According to one aspect, a method according to claim 1 for coating a substrate with at least one cathode assembly is provided. The cathode assembly has a rotatable target with at least one magnet assembly positioned therein. The method includes positioning and operating the at least one magnet assembly for a predetermined first time interval at a first position so that the at least one magnet assembly is asymmetrically aligned with respect to a plane perpendicularly extending from the substrate to the axis of the rotatable target, wherein the predetermined first interval is at least 1 sec. The method further includes positioning and operating the at least one magnet assembly at a second position that is asymmetrically aligned with respect to said plane for a predetermined second time interval and providing a voltage to the rotatable target that is varied over time during coating.

According to aspects of the present disclosure, a coater for coating substrates is provided with at least one cathode assembly having a rotatable curved target and two magnet assemblies positioned within the rotatable curved target of the at least one cathode assembly. The distance between the two magnet assemblies can be varied.

Further aspects, details, advantage and features are apparent from the dependent claims, the description and the accompanying drawings.

Aspects of the present disclosure are also directed to apparatuses for carrying out each of the disclosed methods and including apparatus parts for performing each described method step. These method steps may be performed by way of hardware components, a computer program by appropriate software, by any combination of the two or in any other manner. Furthermore, aspects of the present disclosure are also directed to methods by which the described apparatus operates or by which the described apparatus is manufactured. It includes method steps for carrying out functions of this apparatus or manufacturing parts of the apparatus.

### BRIEF DESCRIPTION OF THE DRAWINGS

Some of the above indicated in other more detailed aspects of the invention will be described in the following description and partially illustrated with reference to the figures. Therein:
Fig. 1, 2, 3a, 3b and 4 are schematic cross sectional views of a coater illustrating the method for coating a substrate according to embodiments described herein;
Fig. 5 is a schematic cross sectional view of a coater;
Fig. 6 is a schematic diagram showing the relation between the angular position of the magnet assemblies and the uniformity of the deposited layer;
Fig. 7 is a schematic diagram showing the relation between the ratio of waiting time to overall coating time and the uniformity of the deposited layer; and
Fig. 8 is a schematic diagram showing exemplarily a square wave voltage applied to the cathode assembly according to embodiments described herein.
Fig. 9 is a schematic diagram showing exemplarily a sine voltage applied to the cathode assembly according to embodiments described herein.
Fig. 10 is a schematic cross sectional view of an array of cathode assemblies positioned for coating a substrate.
Fig. 11 is a schematic diagram showing the resulting deposition profile.

### DETAILED DESCRIPTION OF THE DRAWINGS

Within the following description of the drawings, the same reference numbers refer to the same components. Generally, only the differences with respect to the individual embodiments are described.

The process of coating a substrate with a material as described herein refers typically to thin-film applications. The term "coating" and the term "depositing" are used synonymously herein. The typical coating process used in embodiments described herein is sputtering. Generally, sputtering can be undertaken as diode sputtering or magnetron sputtering. The magnetron sputtering is particularly advantageous in that its deposition rates are rather high. Typically, a magnet is positioned within the rotatable target. The rotatable target as used herein is typically a rotatable curved target. By arranging the magnet or the magnets behind the target, i.e. inside of the target in the event of a rotatable target, in order to trap the free electrons within the generated magnetic field, which is generated directly below the target surface, these electrons are forced to move within the magnetic field and cannot escape. This enhances the probability of ionizing the gas molecules typically by several orders of magnitude. This, in turn, increases the deposition rate magnificently.

The substrate may be continuously moved during coating ("dynamic coating") or the substrate to be coated rests during coating ("static coating"). Static coating is advantageous in that the amount of target material used up for the coating is smaller in comparison to dynamic coating since in the latter case the substrate holders are often coated as well. Static coating particularly allows the coating of large-area substrates. The substrates are entered into a coating area, the coating is performed, and the substrates are taken out of the coating area again.

Sputtering can be used in the production of displays. In more detail, sputtering may be used for the metallization such as the generation of electrodes or buses. It is also used for the generation of thin film transistors (TFTs). It may also be used for the generation of the ITO (indium tin oxide) layer.

Sputtering can also be used in the production of thin-film solar cells. Generally, a thin-film solar cell comprises a back contact, an absorbing layer, and a transparent and conductive oxide layer (TCO). Typically, the back contact and the TCO layer is produced by sputtering whereas the absorbing layer is typically made in a chemical vapour deposition process.

In comparison to an evaporation process such as chemical vapour deposition, sputtering is advantageous in that also materials can be sputtered that cannot be evaporated. Further, the adhesion of the produced layers to the substrate is typically stronger in sputtering processes than in evaporation processes. Further, sputtering is a directional process so that the major part of the material is transferred to the substrate and does therefore not coat the interior of the deposition apparatus (as in evaporation applications).

The term "substrate" as used herein shall embrace both inflexible substrates, e.g., a wafer or a glass plate, and flexible substrates, such as, webs and foils. Typically, the present disclosure is directed at static coating. In most cases, the substrate is an inflexible substrate, such as, a glass plate, e.g., used in the production of solar cells. The term "coating" shall particularly include sputtering. Accordingly, the coater as described herein is typically a sputter apparatus and the cathode assembly is a sputter cathode.

The term "magnet assembly" as used herein is a unit capable of a generating a magnetic field. Typically, the magnet assembly consists of a permanent magnet. This permanent magnet is typically arranged within the rotatable target such that the free electrons are trapped within the generated magnetic field generated below the rotatable target surface. In many embodiments, the magnet assembly comprises a magnet yoke. According to an aspect, the magnet assembly may be movable within the rotatable tube. By moving the magnet assembly, more particularly by rotating the magnet assembly along the axis of the rotatable tube as rotation center, the sputtered material can be directed in different directions.

According to an aspect of the present disclosure, the voltage applied to the rotatable target is varied over time. That is, a non-constant voltage is applied to the rotatable target. Typically, the sputter power is changed depending on the magnet assembly position. Notably, the sputter power is normally directly corresponding to the voltage applied to the rotatable target. Apart from values of close to 0V, the relation between applied voltage and sputter power is linear in a first approximation. Therefore, one way of putting it is that the sputter power is varied over time.

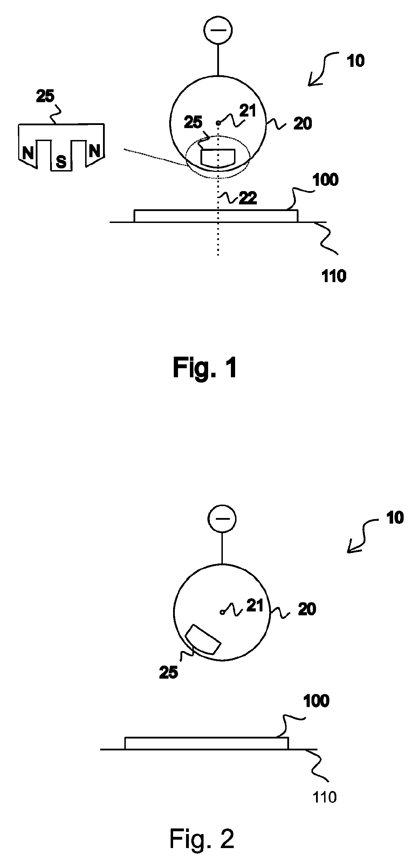

Fig. 1 schematically illustrates a substrate 100 being positioned on a substrate holder 110. The rotatable target 20 of the cathode assembly 10 is positioned over the substrate 100. A negative potential is applied to the rotatable target. A magnet assembly 25 is schematically shown located within the rotatable target 20. In many embodiments, an anode (not shown in Fig. 1), which a positive potential is applied to, is positioned close to the rotatable target. Such an anode may have the shape of a bar, with the bar's axis being typically arranged in parallel to the axis of the angular tube. In other embodiments, a separate bias voltage may be applied to the substrate. "Positioning the magnet assembly" as used herein is generally to be understood as operating the coater with the magnet assembly located at a certain constant position.

A typical permanent magnet as used in embodiments described herein has a two north magnetic poles and a south magnet pole. These poles refer each to a surface of the magnet assembly. The surfaces typically face the rotatable target from its inside.

In many cases, one pole is positioned in the middle whereas two opposite poles are arranged adjacent to it. In Fig. 1, an enlargement of the magnet assembly 25 is shown for illustrating such a situation. As shown, the south pole is positioned in the middle, whereas the north poles enframe the south poles. The pole surfaces' shape may be adapted to the curvature of the rotatable curved target they are positioned in. In many embodiments, the surface of each pole defines a plane. The planes of the magnet poles are typically not parallel. However, the plane defined by the surface of the pole arranged in the middle has an orientation that is typically exactly in the middle of the orientations of the planes defined by the poles of the outer magnet poles. In more mathematical terms, the added vertical vectorial components of the outer pole surfaces sum up exactly to the vertical vectorial component of the inner pole surface.

The term "vertical" in this explanation refers to the vertical orientation as shown in Fig. 1. In more general terms, the term "vertical" refers to the orientation of the substrate. That is, the phrase "the magnet assembly is positioned at a non-zero position" describes a situation wherein a mean surface defined as the vectorial sum of all pole surfaces of the magnet assembly has an orientation that differs from the orientation of the substrate surface.

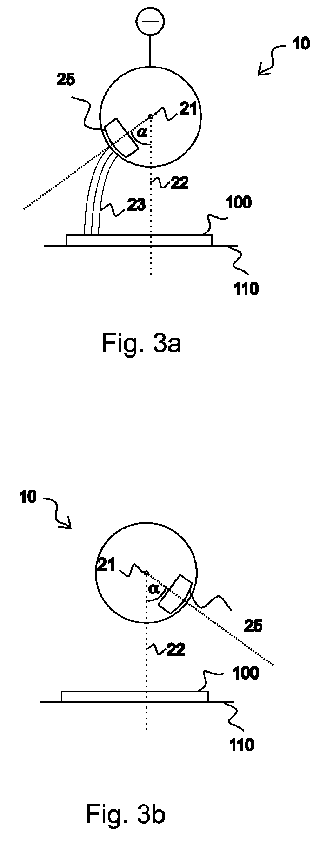

The substrate's surface defines a plane that is horizontally arranged in the figures shown. One can generally think of a plane perpendicularly extending from the substrate to the axis of the rotatable target. In many embodiments, this plane is also perpendicular to the substrate holder. This plane shall be called the "substrate-target interconnection plane" herein. In Figs. 1, 3a and 3b, this plane is exemplarily shown as the vertically arranged dotted line 22.

Although the embodiments shown in the figures illustrate the rotatable target to be arranged above a horizontally arranged substrate and the definition of the substrate-target interconnection plane was illustratively explained with respect to those embodiments, it shall be mentioned that the orientation of the substrate in space can also be vertical. In particular, in view of large-area coating, it might simplify and ease transportation and handling of a substrate if the substrate is oriented vertically. In other embodiments, it is even possible to arrange the substrate somewhere between a horizontal and a vertical orientation.

According to an aspect of the present disclosure, the magnet assembly is asymmetrically aligned with respect to the substrate-target interconnection plane for a predetermined time interval. It shall be noted that the phrase "positioning the magnet assembly asymmetrically aligned for some time" shall be understood as positioning the magnet assembly asymmetrically and keeping it at exactly this position for some time. This predetermined time interval is larger than 1 sec, typically larger than 10 sec, and more typically larger than 30 sec.

Typically, the rotatable curved target has the shape of a cylinder. In order to specify the angular position of elements such as the magnet assembly within the cylinder, one can refer to cylindrical coordinates. Given the particular interest in the angular position, within the present disclosure, the angle is used for the indication of the position. Within the present disclosure, the zero angle position shall be defined as the position within the rotatable target that is closest to the substrate. The zero angle position therefore typically lies within the direct substrate target connection plane 22.

According to aspects of the present disclosure, the magnet assembly is positioned at a non-zero angle position within the rotatable target for a predetermined time interval. This is what is illustrated in Fig. 2. More specifically, it is also shown in Fig. 3a where the magnet assembly 25 is positioned at an angle of -α with respect to the zero angle position. The magnet assembly is then moved to a second non-zero angle position. Fig. 3b illustrates embodiments where the magnet assembly is positioned at an angle of +α with respect to the zero angle position for a predetermined time interval. A negative angle shall refer to a deflection to the left whereas a positive angle shall refer to a deflection to the right as described herein.

Positioning the magnet assembly at a non-zero angle position, i.e., asymmetrically aligned with the substrate-target interconnection plane, results in that the plasma is generated not at that area over the target surface that is closest to the substrate but at an area arranged laterally. Thus, the sputter variance is increased so that such a tilted position of the magnet assembly may result in a higher coating rate of areas that are not supposed to be coated such as the substrate holder or walls within the coating room. In other words, it may thus result in a reduced efficiency.

Despite this situation, it has been surprisingly found out by the inventors of the present disclosure that the homogeneity of the deposited layer on the substrate could be increased by positioning the magnets asymmetrically aligned with the direct substrate target connection plane. When talking about the homogeneity of the layer, this shall be mainly understood as the uniformity of the layer thickness throughout the coated area on the substrate, the crystal structure, the specific resistance, and the stress of the layer.

According to an aspect, when coating a substrate, the magnet assembly is positioned at a first non-zero angle position for a first predetermined time interval. It is then moved to a second non-zero angle position and kept there for a second predetermined time interval. Typically, the first predetermined time interval, i.e., the time interval during which the magnet assembly is kept at a first non-zero angle position, and the second time interval, i.e. the time interval the magnet assembly is positioned at a second non-zero angle position, are identical. Further, according to embodiments, the absolute value of the angle of the first position and the second position is identical. Typically, the second position corresponds to the first position mirrored at the direct substrate target connection plane.

This situation is schematically shown in the Figs. 3a and 3b, wherein the magnet assembly 25 is positioned in a first position in the embodiments of Fig. 3a, i.e., at an angle of -α to the direct substrate target connection plane. In Fig. 3b, the magnet assembly 25 is positioned at a second position defined at an angle α with respect to the direct substrate target connection plane. The illustration of the voltage is shown only in some of the figures for an increased clarity of the figures. However, it shall be understood that, in operation, a negative voltage is typically applied to the cathode assembly.

It has been found out that the uniformity can be further increased if the electrical field, i.e. the voltage, is reduced or switched off at times where the magnet is moved. This is surprising, since it had been proposed to sputter during a constantly moving magnet that wobbles between the left and right maximum angles. Despite this teaching, the inventors have found out that the homogeneity can be increased if sputtering is paused at those times where the magnet assembly is neither located at a first position nor at a second position.

In many embodiments, the optimum homogeneity can be achieved when the electrical field is switched on when the magnets are at outer positions such as at angles of at least 15° or even 25°. Typically, the magnet assembly is waiting at the outer positions for some time. Typically, the electrical voltage is only switched on when the magnet assembly is at the outer positions. During movement of the magnet assembly the discharge is interrupted, i.e., the electrical potential difference between cathode assembly and anode is kept close to zero or zero.

According to embodiments, it is proposed to coat the substrate by sputtering in the following way: The magnet assembly is positioned at a first non-zero angle position within the rotatable target and kept there for a first time interval with the electrical field for sputtering being switched on. For instance, the magnet assembly may be positioned at the angle α. Second, after the first time interval has lapsed, the magnet assembly is moved to the second non-zero angle position, thereby typically passing the zero angle position. During movement the electrical field is switched off. Third, the magnet assembly is kept at a second non-zero angle position for a second time interval with the electrical field being switched on again. The phrase "the electrical field being switched on" is understood as that a voltage is applied to the cathode assembly and the anode.

According to embodiments, the voltage applied is constant during the first time interval and/or the second time interval. The voltage applied is typically equal at those times where the magnet assembly is at the first position and at those times where the magnet assembly is at the second position.

According to typical embodiments, positioning the magnet assembly asymmetrically aligned with the substrate target interconnection plane is undertaken at angles of between 15° and 45°, more typically between 15° and 35° with respect to the zero angle position. In some experiments, it turned out that angles close to 30° result in the best homogeneity of the deposited layer. These exemplary angle values are, of course, understood as absolute values of the angle.

As already set forth, it is typical to position the magnet assembly in a first and a second position wherein the second position has the identical absolute value of the angle but mirrored at the substrate-target interconnection plane.

According to an aspect, the magnet assembly is positioned at a first position, positioned at a second position, positioned at a third position, and positioned at a fourth position. It is held at each position for a predetermined time interval, i.e., at the first position for a first predetermined time interval, at the second position for a second predetermined time interval, at the third position for a third predetermined time interval, and at the fourth position for a fourth predetermined time interval.

According to embodiments, the absolute value of the angle of two of the positions, such as, the third and the fourth position is larger than the absolute value of the other two positions, such as, the first and the second position. Typically, the second position has the identical absolute value of the angle as the first position, however, it is minored about the substrate-target interconnection plane, and/or the fourth position has the identical absolute value of the angle as the third position, however, it is mirrored at the substrate-target interconnection plane. According to embodiments, the positioning sequence corresponds to the position numbering, i.e., the magnet assembly is firstly positioned at the first position, secondly at the second position, thirdly at the third position, and fourthly at the fourth position.

According to further embodiments, which can be combined with other embodiments, the voltage is held at a first non-zero value for a predetermined time interval, and the voltage is held at a second non-zero value for a predetermined time interval. The first non-zero value is optionally larger than the second non-zero value. For instance, the second non-zero voltage value is a maximum of 80% of the first non-zero voltage value or even a maximum of 50% of the first non-zero voltage value.

For instance, the voltage may be held at the first non-zero value when the at least one magnet assembly is positioned at the first position and at the second position. In addition, the voltage may be held at the second non-zero value when the at least one magnet assembly is positioned at the third position and at the fourth position.

According to embodiments, the second position corresponds to the first position mirrored about the substrate-target interconnection plane, and/or the fourth position corresponds to the third position mirrored about the substrate-target interconnection plane.

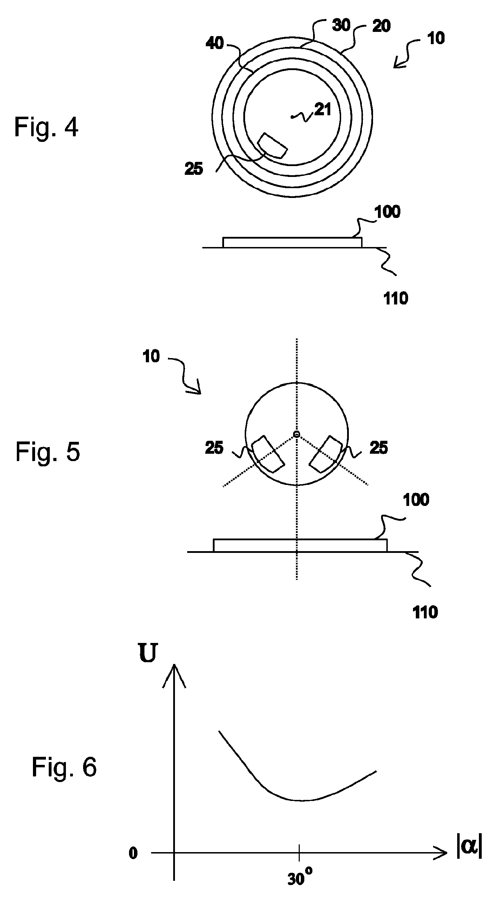

Fig. 4 exemplarily illustrates a cathode assembly as used in embodiments described herein in more detail. It is to be understood that all the elements shown in Fig. 4 may also be applied in other embodiments described herein, in particular in those embodiment described with respect to Figs. 1, 2, 3a, 3b, and 5. What is shown in Fig. 4 is that the rotatable target 20 can be placed on a backing tube. The backing tube is mainly for mounting the rotatable target the material of which is supposed to be cleared away during sputtering. In order to reduce the high temperatures on the target that result from the sputtering process, in many embodiments the rotatable target is aligned with a cooling material tube 40 in its inside. Typically, water is used as cooling material. Cooling is necessary because the major part of the energy put into the sputtering process - typically in the order of magnitude of some kilo Watts - is transferred into heat of the target. As shown in the schematic view of Fig. 4, the magnet assembly is positioned within the backing tube and the cooling material tube so that it can move therein to different angle positions if desired. According to other embodiments, the complete inner part of the target tube is filled with cooling material such as water.

Generally, and not limited to the embodiment of Fig. 4, the magnet assembly may be mounted on the axis of the target tube. A pivoting movement as described herein may be caused by an electromotor providing the necessary rotational force. In typical embodiments, the cathode assembly is equipped with two shafts: A first shaft which the rotatable target tube is mounted on. The first shaft is rotated in operation of the cathode assembly. The movable magnet assembly is typically mounted to the second shaft. The second shaft moves independently from the first shaft, typically in a manner so as to allow the movement of the magnet assembly as described herein.

Fig. 5 shows exemplarily an aspect of the present disclosure with the rotatable curved tube including two magnet assemblies 25. Typically, both magnet assemblies are positioned asymmetrically aligned with respect to the substrate target interconnection plane, i.e., they are positioned at non-zero angle positions. Further, typically, the angle of their position with respect to the zero-angle position is identical with respect to its absolute value. In comparison to the provision of only one magnet assembly per target tube, this configuration allows that two plasmas are generated in front of the target surface adjacent to both magnet assemblies. The sputtering efficiency can thus be increased. Further, by positioning the two magnet assemblies at non-zero angle positions this configuration can benefit from the increased uniformity that could have been observed when positioning the magnet assemblies at non-zero angle positions for predetermined time intervals during operation of the coater.

Typically, the two magnets are positioned at absolute angle values between 15° and 45°, more typically at between 25° and 35° or even between 25° and 30° with respect to the zero angle position. Typically, the absolute angle value of both magnet assemblies with respect to the zero angle position is identical. It is possible to constantly arrange the two magnets at their respective positions. According to embodiments, the second magnet assembly is positioned at a position that refers to the position of the first magnet assembly mirrored at the substrate-target interconnection plane.

According to the disclosure, the at least one cathode assembly includes two magnet assemblies positioned within the rotatable target with the distance between the two magnet assemblies being variable. Typical angles between the two magnet assemblies are between 45° and 75°, for example between 55° and 65°. Generally, the position of the magnet assemblies is not varied with respect to their distance to the rotatable target center. Instead, the magnet assemblies are typically movable along the inner circumference of the rotatable curved target. The indication of a distance between two magnet assemblies in terms of angles is thus derived from the rotatable target center as center of rotation.

According to the disclosure, the same substrate is coated with the magnet assemblies being positioned at different angles with respect to the substrate-target interconnection plane and it is possible to amend the position of the two magnet assemblies during the coating. For instance, the angle between the two magnet assemblies may be set to a value between 15° and 45° in a first step, and to a value of between 35° and 90° in a second step (where the sequence of the steps can be inverted). As discussed, it is possible to set the voltage applied at the first step to a larger value than the voltage applied at the second step.

Within the present disclosure, the figures illustrate cross sectional schematic views of coaters along with exemplarily shown substrates. Typically, the cathode assemblies 10 comprise the rotatable target which has the shape of a cylinder. In other words, the target extends into the paper and out of the paper when looking at the drawings. The same is true with respect to the magnet assemblies that are also only schematically shown as cross sectional elements. The magnet assemblies may extend along the complete length of the cylinder. For technical reasons, it is typical that they extend at least 80 % of the cylinder length, more typically at least 90 % of the cylinder length.

Fig. 6 is a schematic diagram showing the relation between the uniformity U of the deposited layer in dependence on the absolute value of the angle α at which the magnet assembly/assemblies is/are positioned within the rotatable tube. The inventors measured that the curved line representing the uniformity of the deposited layer in terms of deviations from the desired thickness drops up to the angle value of about 30°. The diagram of Fig. 6 further shows that the homogeneity starts to decrease again if the absolute value of the angle α is further increased. Hence, it is typical according to embodiments described herein to adjust the magnet assemblies in the range between about 20° and 40°, more typically between 25° and 35° or even between 25° and 30°.

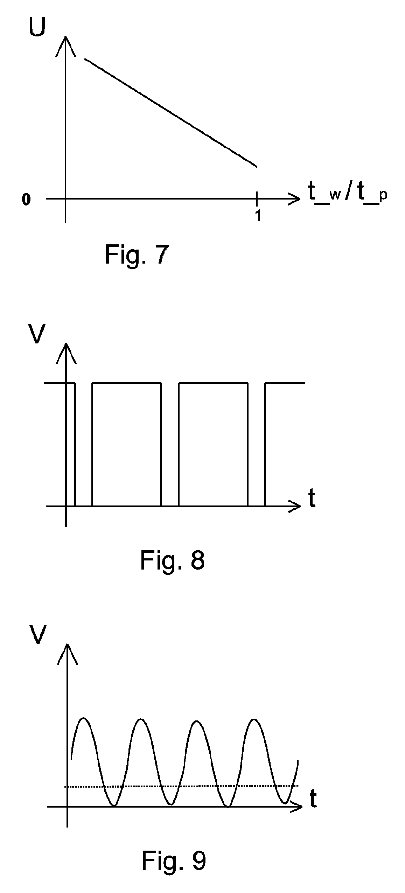

The shown unit "U" refers to the uniformity of the layer measured in percentile variations from the desired layer thickness. At the crossing with the α-axis, the percentage is zero. Although this is of course desirable from a theoretical viewpoint, values like that are hardly reachable. Nonetheless, the present disclosure allows reaching a uniformity of below 3 %, in some embodiments a percentage value even in the range of 2 %. The measured results as shown in Figs. 6 and 7 were measured at a sputtering process of pure copper with a power of about 17.5 kW/meter and a pressure value of about 0.5 Pascal. The substrates that were coated are large area substrates.

Fig. 7 shows a further schematic diagram of the uniformity in dependence of the ratio between t_w and t_p. The time "t_w" represents the overall time at which the magnet assembly is positioned asymmetrically aligned with the substrate-target interconnection plane at a constant angle of larger than 15° such as at an angle of, e.g., 30°. In more detail, the magnet assembly was positioned at the first non-zero angle position for the first time interval and positioned at the second non-zero angle position for the second time interval after being moved to this position.

The time "t_p" is the overall process time of the coating. Hence, at the overall time t_p-t_w the magnet assembly is moved from the first non-zero angle position to the second non-zero angle position with the electrical potential being constant during the complete overall process time t_p. In other terms, this diagram shows how much the uniformity of the substrate improves in dependence on how long the magnet assembly is positioned at a first and/or second non-zero angle position, i.e., asymmetrically aligned with the direct substrate target connection plane. As it can be recognized in the figures, it was found out by the inventors that the longer the magnet assembly is located at the first and second non-zero angle position in relation to the overall process time, the better the homogeneity and, in particular, the uniformity gets.

Therefore, the maximum homogeneity can be achieved by off zero-angle position sputtering. As stated, this can be achieved by arranging two magnets within the rotatable target with typically both magnet assemblies being positioned at a non-zero angle position. It can also be achieved by using only one magnet assembly that is positioned at a first non-zero angle position for some time. This magnet assembly can be moved within the rotatable target to a second non-zero angle position that is typically mirrored to the first non-zero angle position. Normally, it stays there for a second time interval.

According to embodiments, this movement is undertaken at a high speed so that the overall movement time is in the range of below 1 sec, more typically below 0.5 sec. It is further possible to switch off the voltage applied to the target at the time of movement which will further increase the uniformity, as is evident from the diagram of Fig. 7.

Fig. 8 shows the voltage V applied between a substrate and the target for those embodiments were the voltage is non-constant in time but has the shape of a square wave. As it can be seen in the figure, the voltage remains at a certain constant level for some time which is typically the first or the second time interval during sputtering where the magnet assembly is at a constant position. The voltage is then substantially reduced in certain time intervals. These time intervals typically refer to those times where the magnet assembly is moved within the rotatable target, e.g., from the first non-zero angle position to the second position.

According to embodiments, the voltage may be 0 V at those times when it is substantially reduced. Sputtering stops instantly. According to other embodiments, the voltage may be reduced to a certain threshold value that is a kind of initial voltage for the sputtering process. For instance, this threshold voltage may stop sputtering but may allow an easier restart of the sputter process. Typically however, the voltage is reduced to a value of less than 10 % of the sputter voltage, more typically of less than 5 % of the sputter voltage at those times where the magnet assembly moves, i.e. during its relocation.

Generally, it is possible to apply a potential having different shapes. Typically, however, the potential applied is synchronized with the positioning of the magnet assembly. For instance, the potential could drop during movement of the magnet assembly to a value of maximally 35%, more typically maximally 20% of the maximum potential value. For instance, Fig. 9 shows a potential having a sine shape. One could think of an embodiment wherein the magnet assembly is located at constant positions at those times wherein the potential is larger than the dotted line shown in Fig. 9. More plainly, during the coating the magnet assemblies located within the rotatable targets are pivoted from one side to the other side with the sputtering power being varied over the time in dependence on the angular position of the magnet assemblies.

According to embodiments, the magnet assembly is only moved once per substrate. That is, when coating a substrate, the magnet assembly is located at each first and second position only one time. In other embodiments, the magnet assembly may be moved several times. For instance, it may be moved three times so that, when coating a substrate, the magnet assembly is located at each first and second position two times. Although this might increase the overall process time because of the movements and the possible switch off of the sputter power during the movement, it might also further increase the homogeneity of the deposited layer.

The present disclosure is particularly directed at large area substrate coatings. Generally, the term "large area substrates" include substrates with a size of at least 1500 mm x 1800 mm.

According to aspects, a multitude of cathode assemblies each having a rotatable curved target are provided for coating large area substrates. The room adapted for coating a substrate shall be called "coating room". Typically, each coating room is adapted for coating one substrate at one point in time. A multitude of substrates can be coated one after the other.

In many embodiments, the multitude of cathode assemblies is arranged in an array of cathode assemblies. In particular, for static large-area substrate deposition, it is typical to provide a one-dimensional array of cathode assemblies that are regularly arranged. Typically, the number of cathode assemblies is between 2 and 20, more typically between 9 and 16 per coating room.

In typical embodiments, the cathode assemblies are spaced apart from each other equidistantly. It is further typical that the length of the rotatable target is slightly larger than the length of the substrate to be coated. Additionally or alternatively, the cathode array may be slightly broader than the width of the substrate. "Slightly" typically includes a range of between 100% and 110%. The provision of a slightly larger coating length/width helps avoiding boundary effects. Normally, the cathode assemblies are located equidistantly away from the substrate.

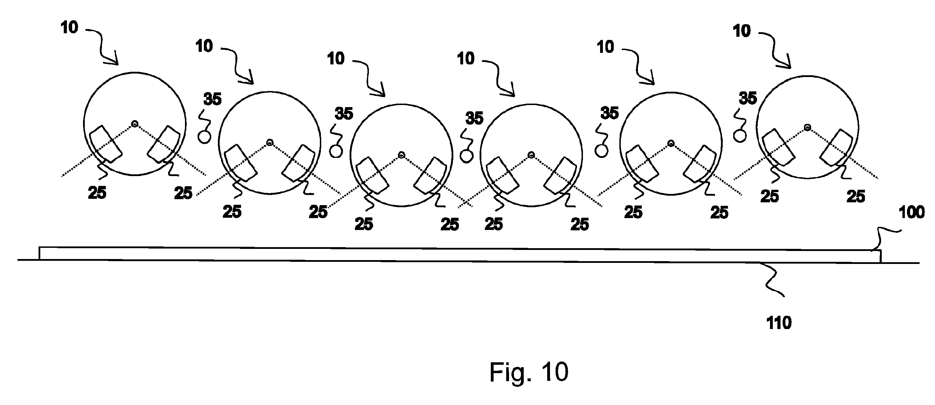

In embodiments, the multitude of cathode assemblies is arranged not in an equidistant fashion with respect to the substrate but along an arc's shape. The shape of the arc may be such that the inner cathode assemblies are located closer to the substrate than the outer cathode assemblies. Such a situation is schematically shown in Fig. 10. Alternatively, it is also possible that the shape of the arc defining the positions of the multitude of cathode assemblies is such that the outer cathode assemblies are located closer to the substrate than the inner cathode assemblies. The scattering behaviour depends on the material to be sputtered. Hence, depending on the application, i.e. on the material to be sputtered, providing the cathode assemblies on an arc shape will further increase the homogeneity. The orientation of the arc depends on the application.

In addition, Fig. 10 shows exemplarily anode bars positioned between the cathode assemblies that may be used in some of the embodiments described herein.

According to array embodiments, the respective magnet assemblies in each rotatable target are moved from the first position to the second position synchronously. A synchronous movement further increases the homogeneity of the layer.

Further, in array embodiments the angle of the first and second position of the multiple rotatable targets may be identical. It is also possible, however, that the angles differ with respect to different rotatable targets. More particularly, they may differ in dependence on the position of the cathode assembly with respect to the substrate. For example, it is possible that the angles the magnet assemblies are moved to in outer cathode assemblies are larger or smaller than the angles the magnet assemblies of the inner cathode assemblies are moved to. By making use of this method of operation, it may be possibly to further enhance the effect of the arc arrangement or, in case the cathode assemblies are positioned equidistantly away from the substrate, to simulate arc positioning.

In addition to positioning the magnet assembly at at least two positions within the rotatable target, it is alternatively or additionally possible to wobble the substrate. The term "wobbling" the substrate shall be understood as moving the substrate back and forth within a limited distance. Typically, the substrate is positioned at a first position for a predetermined time interval, and it is positioned at a second position for a predetermined time interval. In further embodiments, the substrate may additionally be positioned at a third position and a fourth position.

In the following, embodiments resulting in a particularly high uniformity shall be described.

It has been observed by the inventors that arcing increases non-linearly with increasing process powers and angles of the magnet assemblies. Arcing is detrimental to the deposition process and must be minimized. However, as previously described, it is desirable to position the magnet assembly at large angles (e.g., 30°) since larger angles increase the uniformity. Further, high process voltages allow for a high throughput reducing the overall processing time and costs.

The inventors have found a particularly optimized method taking into consideration both the throughput time and the uniformity optimization. Thereby, a layer with a high degree of uniformity can be obtained by the superposition of several sub-layers wherein each sub-layer is deposited at a specific voltage and at a specific angle. Typically, four deposition steps are undertaken in order to achieve a layer with a high uniformity. The process can be implemented without or with only few arc occurrences, and at a high throughput rate. The sequence of the steps can typically be of any kind.

According to this embodiment, a first deposition step is undertaken with the magnet assembly being positioned at a first position and the voltage being set to a first voltage value for a predetermined first time interval. This is followed by a second deposition wherein the magnet assembly is positioned at a second position, and the voltage is set to the first voltage value for a predetermined first time interval. The second position corresponds to the first position mirrored about the substrate-target interconnection plane. In particular, the absolute angles of the first and second position are identical.

A further deposition step may be undertaken with the magnet assembly being positioned at a third position, and the voltage set to a second voltage value for a predetermined second time interval. This may be followed by a fourth deposition wherein the magnet assembly is positioned at a fourth position, and the voltage is set to the second voltage value for a predetermined second time interval. The fourth position typically corresponds to the third position mirrored about the substrate-target interconnection plane. In particular, the absolute angles of the third and fourth position are identical.

According to embodiments, the predetermined first time interval and the predetermined second time interval are identical. Alternatively or additionally, the predetermined third time interval and the predetermined fourth time interval may be identical. The term "identical" as used herein shall be understood as including a deviation of maximally 15%.

According to embodiments, the first time interval is larger than the second time interval. For instance, the first time interval may be between 20 sec and 1min, for example about 30 sec. The second time interval is a compromise between maximum uniformity and acceptable overall deposition time. Typically, the second time interval is smaller than 30 sec or even smaller than 15 sec. In this embodiment, the first voltage value is larger than the second voltage value, whereas, at the same time, the absolute value of the angles of the first and second position is smaller than the absolute value of the angles of the third and fourth position. Typically, most of the material is deposited during the deposition at the first voltage. One or more of the typical values can be chosen as follows. The first voltage is typically at least 40 kW. The second voltage is typically smaller than 30 kW. The first angle is typically smaller than 20°. The second angle is typically larger than 35°.

According to embodiments, the voltage is kept at the first non-zero value during positioning the at least one magnet assembly at the first position and during positioning the at least one magnet assembly at the second position for a predetermined time interval. Additionally or alternatively, the voltage is kept at a second non-zero value during positioning the at least one magnet assembly at the third position and during positioning the at least one magnet assembly at the fourth position for another predetermined time interval. Typically, the first non-zero value is larger than the second non-zero value. That is, the voltage is typically non-zero at those times where the magnet assembly rests at one or all of the first, second, third or fourth position.

Typically, the voltage is reduced to a value of less than 10 %, more typically of less than 5 % of the first non-zero value or the second non-zero value during relocating the magnet assembly.

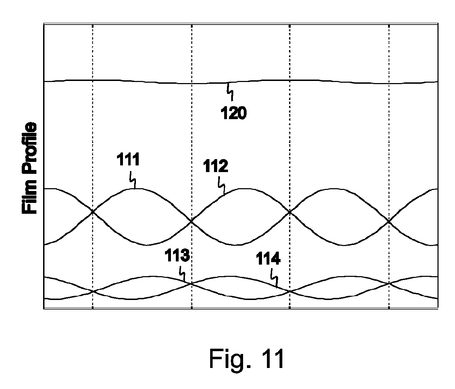

Fig. 11 schematically shows several film profiles measured after deposition processes. The y-axis represents a metrical unit for the film's height, whereas the x-axis represents a metrical unit for the substrate's length. The deposition takes place by an array of cathodes so that each deposition setting results in a kind of sinusoidal shape.

The deposition with the magnet assembly at the first position results in a film profile 111, and the deposition with the magnet assembly at the second position results in a film profile 112.

The depositions were undertaken at a relatively high voltage with a relatively small angle (the relation corresponds to the third and fourth depositions). The deposition with the magnet assembly at the third position results in a film profile 113, and the deposition with the magnet assembly at the fourth position results in a film profile 114. The depositions were undertaken at a relatively small voltage with a relatively high angle (in relation to the depositions at the first and second position).

The resulting overall film profile is shown as profile 120. It is a superposition of the four depositions with the film profiles 111, 112, 113, and 114. As it is evident from the schematic drawing, the resulting profile has a high degree of uniformity. Further, the process time is acceptable since the major material deposition takes place during the first and second deposition step. Since this requires high deposition power, i.e. high voltage, the angle of the magnet assembly is relatively small as compared to the third and fourth deposition step in order to prevent arcing. As it can be seen in the example Fig. 11, the phase difference between the deposited layers 111 and 112, however, is smaller than 180° so that the ripple is only partially compensated.

The resulting lack of uniformity is compensated for by performing the third and fourth deposition steps. These steps mainly aim at compensating for the wave shape of the film profile produced by the first and second deposition step. The angle of the magnet assembly in the third and fourth process step is comparably large. The overall material deposition of the third and fourth process step is small since the deposition power, i.e. the voltage, is kept at a comparably small value in order to avoid arcing. As can be seen in the example illustrated in Fig. 11, the phase difference of the deposited layers 113 and 114 is larger than 180°. Thus, typically, the resulting sinusoidal profile is out of phase with the cathode array periodicity and/or the layer profiles of the first and second deposition so that the remaining ripple is compensated.

Any sequence is possible alternatively to the described sequence of steps. In particular, in order to reduce the necessary relocation time of the magnet assembly, it is possible to firstly undertake the first and third steps, and secondly the second and fourth step. Thereby, the magnet assembly does not cross the substrate-target interconnection plane between the first and third step or between the second and fourth step. Generally, the order of the four depositions is determined by the process cycle-time and the morphological film characteristics.

The method and coater as disclosed herein can be used for depositing material on substrates. More particularly, they allow a high uniformity of the deposited layer and can therefore be used in the production of displays such as flat panel displays, e.g., TFTs. It may also be used in the production of solar cells, in particular of thin-film solar cells. Given the improved uniformity, as a further effect thereof, the overall material consumption can be reduced which is particularly desirable when using expensive materials. For instance, the proposed method and coater could be used for the deposition of an indium tin oxide (ITO) layer in the production of a flat panel display or a thin film solar cell.

Alternatively or additionally, the film distributions may be formed by varying the relative position between the rotatable target and the substrate wherein the positions are maintained for predetermined time intervals as described in the application "Systems and methods for forming a layer of sputter material" filed by Applied Materials with the European Patent Office on September 30, 2010.

In particular, specific embodiments of the mentioned patent application describing the variation of the relative positions of the target and the substrate shall also be applicable to the present disclosure wherein the relative positions of the target and the substrate shall be understood as the relative positions between the magnet assembly within the target and the substrate herein.

While the foregoing is directed to embodiments of the invention, the invention is defined by the claims.

## Claims

1. A method for coating a substrate (100) with a coater comprising at least one cathode assembly (10) having
a rotatable target (20), the rotatable target having at least one magnet assembly (25) positioned there within, the method comprising
- operating the coater with the at least one magnet assembly at a first position so that the at least one magnet assembly is asymmetrically aligned with respect to a plane (22) perpendicularly extending from the substrate (100) to the axis (21) of the rotatable target for a predetermined first time interval;
- moving the at least one magnet assembly to a second position that is asymmetrically aligned with respect to said plane (22) and operating the coater with the at least one magnet assembly at said second position for a predetermined second time interval; and
- providing a voltage to the rotatable target that is varied over time during coating;
**characterised in that** the predetermined first time interval is at least 1 second.

2. The method according to claim 1, wherein the at least one magnet assembly is positioned asymmetrically aligned for at least 80%, preferably at least 95% of the overall coating time.

3. The method according to any of the preceding claims, wherein said plane defines the zero angle position within the rotatable target with the magnet assembly (25) being positioned at an angle of between 15° and 45°, preferably between 25° and 35°.

4. The method according to any of the preceding claims, further comprising
- moving the at least one magnet assembly from the first position to the second position with the voltage being preferably substantially zero during movement of the magnet assembly from the first position to the second position.

5. The method according to any of the preceding claims wherein the voltage, which is varied over time, has a square waveform.

6. The method according to any of the preceding claims, wherein the voltage is kept at a first non-zero value for a predetermined time interval, and the voltage is kept at a second non-zero value for another predetermined time interval, wherein the first non-zero value is larger than the second non-zero value.

7. The method according to any of the preceding claims, further comprising:
- positioning the at least one magnet assembly at a third position that is asymmetrically aligned with respect to said plane (22) for a predetermined third time interval; and
- positioning the at least one magnet assembly at a fourth position that is asymmetrically aligned with respect to said plane (22) for a predetermined fourth time interval;
wherein the absolute value of the angle of two of the positions is larger than the angle of the other two positions.

8. The method according to claim 7 if dependent on claim 6, wherein
- the voltage is kept at the first non-zero value during positioning the at least one magnet assembly at the first position and during positioning the at least one magnet assembly at the second position; and
- the voltage is kept at the second non-zero value during positioning the at least one magnet assembly at the third position and during positioning the at least one magnet assembly at the fourth position.

9. The method according to claim 8, wherein the angle of the first and second position is smaller than the angle of the third and fourth position.

10. The method according to any of claims 7, 8, or 9, wherein the positioning of the at least one magnet assembly at the first and second position is undertaken prior to positioning of the at least one magnet assembly at the third and fourth position.

11. The method according to any of the claims 7-10, wherein the second position corresponds to the first position mirrored at said plane, and/or the fourth position corresponds to the third position mirrored at said plane.

12. The method according to any of the claims 7-11, wherein the predetermined first time interval and the predetermined second time interval are identical, and/or the predetermined third time interval and the predetermined fourth time interval are identical.

## Patentansprüche

1. Verfahren zum Beschichten eines Substrats (100) mit einer Beschichtungsvorrichtung, die mindestens eine Kathodenbaugruppe (1) mit einem drehbaren Target (20) aufweist, wobei das drehbare Target mindestens eine darin befindliche Magnetbaugruppe (25) hat, wobei das Verfahren umfasst:
- Betätigen der Beschichtungsvorrichtung, wobei sich die mindestens eine Magnetbaugruppe an einer ersten Position befindet,
so, dass die mindestens eine Magnetbaugruppe in Bezug auf eine Ebene (22), die sich senkrecht vom Substrat (100) zur Achse (21) des drehbaren Targets erstreckt, über ein vorbestimmtes erstes Zeitintervall asymmetrisch ausgerichtet ist;
- Bewegen der mindestens einen Magnetbaugruppe zu einer zweiten Position, die in Bezug auf die Ebene (22) asymmetrisch ausgerichtet ist, und Betätigen der Beschichtungsvorrichtung, wobei sich die mindestens eine Magnetbaugruppe über ein vorbestimmtes zweites Zeitintervall an der zweiten Position befindet; und
- Bereitstellen einer Spannung für das drehbare Target, die mit der Zeit während des Beschichtens verändert wird;
**dadurch gekennzeichnet, dass** es sich bei dem ersten vorbestimmten Zeitintervall um mindestens 1 Sekunde handelt.

2. Verfahren nach Anspruch 1, wobei die mindestens eine Magnetbaugruppe über mindestens 80%, vorzugsweise mindestens 95% der Gesamtbeschichtungszeit asymmetrisch ausgerichtet angeordnet ist.

3. Verfahren nach einem der vorhergehenden Ansprüche, wobei die Ebene die Nullwinkelposition im drehbaren Target definiert, wobei die Magnetbaugruppe (25) in einem Winkel von zwischen 15° und 45°, vorzugsweise zwischen 25° und 35° angeordnet ist.

4. Verfahren nach einem der vorhergehenden Ansprüche, darüber hinaus umfassend:
- Bewegen der mindestens einen Magnetbaugruppe von der ersten Position zur zweiten Position, wobei die Spannung während der Bewegung der Magnetbaugruppe von der ersten Position zur zweiten Position im Wesentlichen Null beträgt.

5. Verfahren nach einem der vorhergehenden Ansprüche, wobei die Spannung, die mit der Zeit verändert wird, eine Rechteck-Wellenform hat.

6. Verfahren nach einem der vorhergehenden Ansprüche, wobei die Spannung über ein vorbestimmtes Zeitintervall auf einem ersten, nicht Null betragenden Wert gehalten wird, und die Spannung über ein anderes vorbestimmtes Zeitintervall auf einem zweiten, nicht Null betragenden Wert gehalten wird, wobei der erste, nicht Null betragende Wert größer ist als der zweite, nicht Null betragende Wert.

7. Verfahren nach einem der vorhergehenden Ansprüche, darüber hinaus umfassend:
- Anordnen der mindestens einen Magnetbaugruppe über ein vorbestimmtes drittes Zeitintervall an einer dritten Position, die in Bezug auf die Ebene (22) asymmetrisch ausgerichtet ist; und
- Anordnen der mindestens einen Magnetbaugruppe über ein vorbestimmtes viertes Zeitintervall an einer vierten Position, die in Bezug auf die Ebene (22) asymmetrisch ausgerichtet ist;
wobei der Absolutwert des Winkels zweier der Positionen größer ist als der Winkel der anderen zwei Positionen.

8. Verfahren nach Anspruch 7, falls von Anspruch 6 abhängig, wobei
- die Spannung während des Anordnens der mindestens einen Magnetbaugruppe an der ersten Position und während des Anordnens der mindestens einen Magnetbaugruppe an der zweiten Position auf dem ersten, nicht Null betragenden Wert gehalten wird; und
- die Spannung während des Anordnens der mindestens einen Magnetbaugruppe an der dritten Position und während des Anordnens der mindestens einen Magnetbaugruppe an der vierten Position auf dem zweiten, nicht Null betragenden Wert gehalten wird.

9. Verfahren nach Anspruch 8, wobei der Winkel der ersten und zweiten Position kleiner ist als der Winkel der dritten und vierten Position.

10. Verfahren nach einem der Ansprüche 7, 8 oder 9, wobei das Anordnen der mindestens einen Magnetbaugruppe an der ersten und zweiten Position vor dem Anordnen der mindestens einen Magnetbaugruppe an der dritten und vierten Position erfolgt.

11. Verfahren nach einem der Ansprüche 7 bis 10, wobei die zweite Position der an der Ebene gespiegelten ersten Position entspricht, und/oder die vierte Position der an der Ebene gespiegelten dritten Position entspricht.

12. Verfahren nach einem der Ansprüche 7 bis 11, wobei das vorbestimmte erste Zeitintervall und das vorbestimmte zweite Zeitintervall identisch sind und/oder das vorbestimmte dritte Zeitintervall und das vorbestimmte vierte Zeitintervall identisch sind.

## Revendications

1. Procédé de revêtement d'un substrat (100) au moyen d'un dispositif de revêtement comprenant au moins un ensemble cathode (10) présentant
une cible rotative (20), la cible rotative présentant au moins un ensemble aimant (25) positionné dans celle-ci, le procédé comprenant
- le fait de faire fonctionner le dispositif de revêtement avec l'au moins un ensemble aimant dans une première position de telle sorte que l'au moins un ensemble aimant soit aligné asymétriquement par rapport à un plan (22) s'étendant perpendiculairement du substrat (100) à l'axe (21) de la cible rotative pendant un premier intervalle de temps prédéterminé ;
- le fait de déplacer l'au moins un ensemble aimant dans une deuxième position qui est alignée asymétriquement par rapport audit plan (22) et de faire fonctionner le dispositif de revêtement avec l'au moins un ensemble aimant dans ladite deuxième position pendant un deuxième intervalle de temps prédéterminé ; et
- le fait de fournir à la cible rotative une tension que l'on fait varier dans le temps pendant le revêtement ;
**caractérisé en ce que** le premier intervalle de temps prédéterminé est d'au moins 1 seconde.

2. Le procédé selon la revendication 1, sachant que l'au moins un ensemble aimant est positionné de manière asymétriquement alignée pendant au moins 80%, de préférence au moins 95% du temps de revêtement total.

3. Le procédé selon l'une quelconque des revendications précédentes, sachant que ledit plan définit la position d'angle zéro à l'intérieur de la cible rotative, l'ensemble aimant (25) étant positionné à un angle compris entre 15° et 45°, de préférence entre 25° et 35°.

4. Le procédé selon l'une quelconque des revendications précédentes, comprenant en outre
- le fait de déplacer l'au moins un ensemble aimant de la première position à la deuxième position, la tension étant de préférence sensiblement de zéro pendant le déplacement de l'ensemble aimant de la première position à la deuxième position.

5. Le procédé selon l'une quelconque des revendications précédentes, sachant que la tension, que l'on fait varier dans le temps, a une forme d'onde carrée.

6. Le procédé selon l'une quelconque des revendications précédentes, sachant que la tension est maintenue à une première valeur autre que zéro pendant un intervalle de temps prédéterminé, et la tension est maintenue à une deuxième valeur autre que zéro pendant un autre intervalle de temps prédéterminé, sachant que la première valeur autre que zéro est plus grande que la deuxième valeur autre que zéro.

7. Le procédé selon l'une quelconque des revendications précédentes, comprenant en outre :
- le fait de positionner l'au moins un ensemble aimant dans une troisième position qui est alignée asymétriquement par rapport audit plan (22) pendant un troisième intervalle de temps prédéterminé ; et
- le fait de positionner l'au moins un ensemble aimant dans une quatrième position qui est alignée asymétriquement par rapport audit plan (22) pendant un quatrième intervalle de temps prédéterminé ;
sachant que la valeur absolue de l'angle de deux des positions est plus grande que l'angle des deux autres positions.

8. Le procédé selon la revendication 7 si elle dépend de la revendication 6, sachant que
- la tension est maintenue à la première valeur autre que zéro pendant le positionnement de l'au moins un ensemble aimant dans la première position et pendant le positionnement de l'au moins un ensemble aimant dans la deuxième position ; et
- la tension est maintenue à la deuxième valeur autre que zéro pendant le positionnement de l'au moins un ensemble aimant dans la troisième position et pendant le positionnement de l'au moins un ensemble aimant dans la quatrième position.

9. Le procédé selon la revendication 8, sachant que l'angle de la première et de la deuxième position est plus petit que l'angle de la troisième et de la quatrième position.

10. Le procédé selon l'une quelconque des revendications 7, 8, ou 9, sachant que le positionnement de l'au moins un ensemble aimant dans la première et la deuxième position est effectué avant le positionnement de l'au moins un ensemble aimant dans la troisième et la quatrième position.

11. Le procédé selon l'une quelconque des revendications 7 à 10, sachant que la deuxième position correspond à la première position reflétée en miroir au niveau dudit plan, et/ou la quatrième position correspond à la troisième position reflétée en miroir au niveau dudit plan.

12. Le procédé selon l'une quelconque des revendications 7 à 11, sachant que le premier intervalle de temps prédéterminé et le deuxième intervalle de temps prédéterminé sont identiques, et/ou le troisième intervalle de temps prédéterminé et le quatrième intervalle de temps prédéterminé sont identiques.
